# NEUE EUROPÄISCHE PATENTSCHRIFT

(11) **EP 0 239 736 B2**
(45) Veröffentlichungstag und Bekanntmachung des Hinweises auf die Entscheidung über den Einspruch: **25.10.1995**
(45) Hinweis auf die Patenterteilung: 31.07.1991
(21) Anmeldenummer: 87101190.4
(22) Anmeldetag: 28.01.1987
(51) Int. Cl.: C25D 17/06, C25D 17/08, H01L 21/22

(54) **Langgestreckte Gestelle und zugehörige Teile zum lösbaren Befestigen von zu galvanisierenden Leiterplatten, sowie zugehörige Leiterplatten**
Elongate racks for the detachable attachment of circuit boards to be galvanized, and associated circuit boards and parts
Cadres longs et pièces appartenant à ceux-ci pour fixer de façon détachable des circuits imprimés à galvaniser, ainsi que des circuits imprimés correpsondants

(30) Priorität: 28.02.1986 DE 3606492
(43) Veröffentlichungstag der Anmeldung: 07.10.1987
(73) Patentinhaber: SCHERING AKTIENGESELLSCHAFT, 13342 Berlin (DE)
(72) Erfinder: Kreisel, Rudolf, D-8500 Nürnberg 10 (DE); Pistor, Dieter, D-8503 Altdorf (DE); Mankut, Ludwig, D-8503 Altdorf (DE); Kosikowski, Thomas, D-8500 Nurnberg 50 (DE); Gaebel, Rolf, D-1000 Berlin 47 (DE); Haase, Peter, D-8501 Feucht (DE); Kuhn, Peter, D-1000 Berlin 28 (DE)
(74) Vertreter: Richter, Bernhard, Dipl.-Ing.

(56) Entgegenhaltungen:
- AT-B- 363 749
- DD-B- 160 317
- DE-A- 3 116 897
- GB-A- 2 016 048
- US-A- 3 013 959
- US-A- 4 425 212
- US-A- 4 519 887
- PATENT ABSTRACTS OF JAPAN, unexamined applications, c feld, Band 10, Nr. 90, 8. April 1986 THE PATENT OFFICE JAPANESE GOVERNMENT, Seite 93 C 337

## Beschreibung

Die Erfindung betrifft langgestreckte Gestelle und zugehörige Teile zum lösbaren Befestigen von Leiterplatten für die nachfolgende Galvanisierung mit Mitteln, um die Leiterplatten an ihren beiden einander gegenüberliegenden Längsseitenrändern zu halten, wobei die Haltemittel auch der Stromzuführung dienen (Oberbegriff des Anspruches 1). Hierzu sind (siehe DE-OS 31 16 897) Haltemittel in Form von Knebelschrauben bekannt, die von Hand angezogen und gegen die Plattenränder gepreßt werden mußten. Eine solche Handarbeit ist sehr umständlich. Sofern sich an diesen Halterungen vom vorhergehenden Bad noch Säurereste befinden, müssen die Arbeitskräfte Schutzhandschuhe tragen. Da diese Halterungen nicht nur die Funktion des Haltens haben sollen, sondern auch zugleich den der Galvanisierung dienenden Strom auf die Leiterplatten übertragen müssen, besteht der weitere Nachteil, daß die Stromübergangskontakte von den Spitzen der Knebelschrauben zu den Platten relativ klein sind. Dadurch entsteht an diesen Übergangsstellen ein sehr störender Spannungsabfall (hierbei ist zu berücksichtigen, daß in galvanischen Anlagen mit Niederspannung von 6 V gearbeitet wird). Ähnliche Anordnungen sind der AT-PS 363749 und der DD-PS 160317 zu entnehmen, die ebenfalls für den Halt einer Leiterplatte mehrere von Hand zu betätigende Klemmschrauben aufweisen. Außerdem offenbaren die vorgenannten Literaturstellen nur einen Halt der Leiterplatten an einer Längsseite, die Leiterplatte steht also frei von dem langgestreckten Gestell vor. Aus US-PS 3013959 ist eine Anordnung bekannt, bei der die waagerechten oberen Ränder von Leiterplatten mittels Klemmitteln gehalten' werden, die jeweils von Hand in die Haltelage oder in die Nichthaltelage gebracht werden müssen. Hinzu kommt, daß die bei US-PS 3013959 vorgesehenen Klemmittel nicht der Stromübertragung dienen.

Die Aufgabe der Erfindung besteht demgegenüber darin, ein schnell und in der Bedienung vereinfachtes Befestigen bzw. Abnehmen von Leiterplatten an bzw. von den Gestellen zu erreichen. Dabei ist primär an Leiterplatten mit gedruckten Schaltungen für die Elektronik gedacht.

Die Lösung dieser Aufgabe wird, ausgehend vom Oberbegriff des Anspruches 1, zunächst darin gesehen, daß zwei einander parallele und im Abstand angeordnete Gestelle jeweils in sich federnde Klemmhalterungen aufweisen, daß diese Klemmhalterungen von jedem Gestell her frei wegragen und zwar in den Raum zwischen diesen beiden Gestellen hinein und daß Mittel vorgesehen bzw. die Klemmhalterungen so ausgebildet sind, daß ein Einbringen bzw. Wiederherausnehmen der jeweiligen Längsseitenränder der zu galvanisierenden Flächen der Leiterplattan in die bzw. aus den federnden Klemmhalterungen dieser beiden Gestelle entweder durch Einschieben der Leiterplatten in deren Klemmhalterungen oder dadurch ermöglicht ist, daß ein Teil der Klemmfedern der federnden Klemmhalterungen am jeweiligen Gestell in die Klemmlage schwenkbar und aus dieser in eine Freigabestellung ausschwenkbar gelagert ist (Kinnzeichens des Anspruches 1). In der ersten Alternative des Anspruches 1 sind die maschinell, z.B. von Greifern, zu erfassenden Leiterplatten von diesen in die Klemmhalterungen einschiebbar, wobei Teile des Gestells nicht hindernd im Wege stehen. Ebenso leicht und maschinell, d.h. ohne Handarbeit, sind die Leiterplatten nach dem Galvanisieren von den Gestellen durch Herausziehen abnehmbar. Die Stromübergangskontakte von den Klemmhalterungen zu den Leiterplatten können eine genügend große Fläche erhalten. Ebenso leicht ist die Anbringung und das Abnehmen der Leiterplatten gemäß der zweiten Alternative des Anspruches 1 mit Hilfe einer Verschwenkung von Teilen der Klemmhalterung durchzuführen. Während man bei den erläuterten vorbekannten Anordnungen mit Klemm- oder Knebelschrauben bemüht sein mußte, die Zahl der Schrauben nicht zu groß werden zu lassen, da dies zuviel Handarbeit erfordert hätte, muß man sich jedoch aus diesem Grund beim Gegenstand der Erfindung in der Zahl der federnden Klemmhalterungen nicht beschränken und kann daher die hiervon insgesamt gebildete Kontaktfläche genügend groß machen. Das Beschicken der mit Klemmitteln gemäß der Erfindung versehenen Gestelle mit den Leiterplatten kann aber auch von Hand erfolgen. Auch dabei wird gegenüber dem erläuterten Stand der Technik eine wesentliche Bedienungsvereinfachung erreicht, da das umständliche und zeitraubende Anziehen und Lösen der Klemm- oder Knebelschrauben in Fortfall kommt. Außerdem kann es bei Schraubbefestigungen durch Nachlässigkeit des Personals geschehen, daß die Schrauben nicht genügend fest angezogen werden. Auch dieser Nachteil ist mit der Erfindung vermieden. Die im Anspruch 1 angegebene Erstreckung der Klemmhalterung in den Raum zwischen den Gestellen begünstigt den Galvanisiervorgang und erlaubt den Halt der Leiterplatten zwischen und mittels zweier Gestelle. Die durch die Gestelle zu ergreifenden Längsseitenränder der Leiterplatten verlaufen somit in der vorgenannten Haltelage in Längsrichtung der Gestelle. In dem Zusammenhang erlauben die Merkmale des Anspruches 2 ein einfaches Einschieben dem Leiterplatten in der Gestell-Längsrichtung, z.B. von unten her, wobei die Formgebung der Klemmfederhalterungen dies erleichtert (siehe insbesondere Anspruch 3). Bei Vorhandensein mehrerer Gestelle brauchen zum Einschieben der Leiterplatten diese nicht horizontal verschoben zu werden. Die Merkmale der Unteransprüche 4 bis 10 betreffen weitere vorteilhafte Ausgestaltungen der Klemmfederhalterungen und der zugehörigen Gestelle.

Die Merkmale der Ansprüche 11 bis 13 betreffen Ausgestaltungen der Erfindung, die zusätzlich zur Klemmhalterung ein Anhängen der Leiterplatten an den Gestellen ermöglicht.

Die Ansprüche 14 bis 22 betreffen weitere Möglichkeit nach der Erfindung, um die federnde Klemmhalterung herzustellen, bzw. freizugeben. Anspruch 23 betrifft eine besonders vorteilhafte Ausgestaltung der Klemmfedern.

Die Ansprüche 24 und 25 befassen sich mit einer vorteilhaften und für Galvanikzwecke widerstandsfähigen Ausbildung der Gestelle.

Weitere Vorteile und Merkmale der Erfindung sind den Einzelheiten der Ansprüche sowie der nachstehenden Beschreibung und der zugehörigen Zeichnung von erfindungsgemäßen Ausführungsbeispielen zu entnehmen. In der Zeichnung zeigt:
- Fig. 1:: schematisch in der Frontalansicht zwei Gestelle mit zwei eingeschobenen Leiterplatten,
- Fig. 2,3:: in der Seitenansicht und in der Draufsicht eine Ausführungsform der Erfindung in einem gegenüber Fig. 1 vergrößerten Maßstab,
- Fig. 4:: ein weiteres Ausführungsbeispiel der Erfindung in einem Schnitt gemäß der Linie IV-IV in Fig. 1, jedoch mit einer anderen Ausbildung der Klemmfedern,
- Fig. 5:: eine Ansicht auf Fig. 4 gemäß dem Pfeil V, wobei Fig. 4 und 5 etwa im Maßstab der Fig. 2 und 3 gehalten sind.
- Fig. 6:: in einem Maßstab etwa gemäß Fig. 1 ein weiteres Ausführungsbeispiel der Erfindung in der Frontalansicht.
- Fig.7-9:: im wieder vergrößerten Maßstab und in verschiedenen Ansichten Teile der Einzelheit Z,
- Fig. 10:: ein weiteres Ausführungsbeispiel der Erfindung ebenfalls in der Frontalansicht und im Maßstab etwa gemäß den Fig. 1 und 6,
- Fig.10a:: eine Seitenansicht zu Fig. 10,
- Fig. 11:: im vergrößerten Maßstab einen Schnitt gemäß der Linie XI-XI in Fig. 10,
- Fig. 12-14:: ein weiteres Ausführungsbeispiel der Klemmfederhalterung nach der Erfindung im vergrößerten Maßstab, z.T. in Ansichten, z.T. im Schnitt,
- Fig. 15:: in ebenfalls vergrößertem Maßstab einen Schnitt durch ein Ausführungsbeispiel der Gestelle.
- Fig. 16:: ein Ausführungsbeispiel ähnlich Fig. 10, jedoch in einer anderen Ausführung.
- Fig. 17:: im vergrößerten Maßstab einen Schnitt gemäß der Linie XVII-XVII in Fig. 16.
- Fig. 18:: in einem Teilausschnitt die Draufsicht auf Fig. 17.

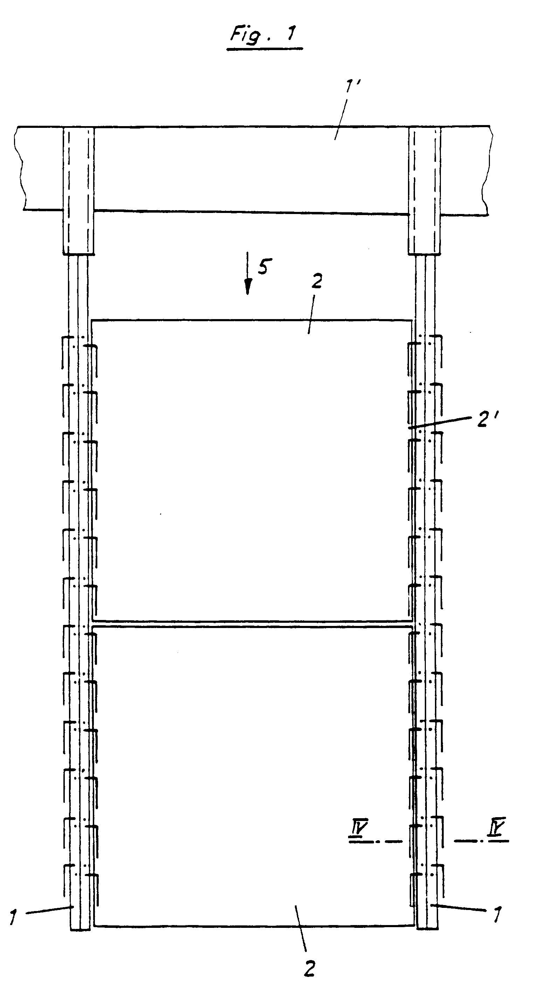

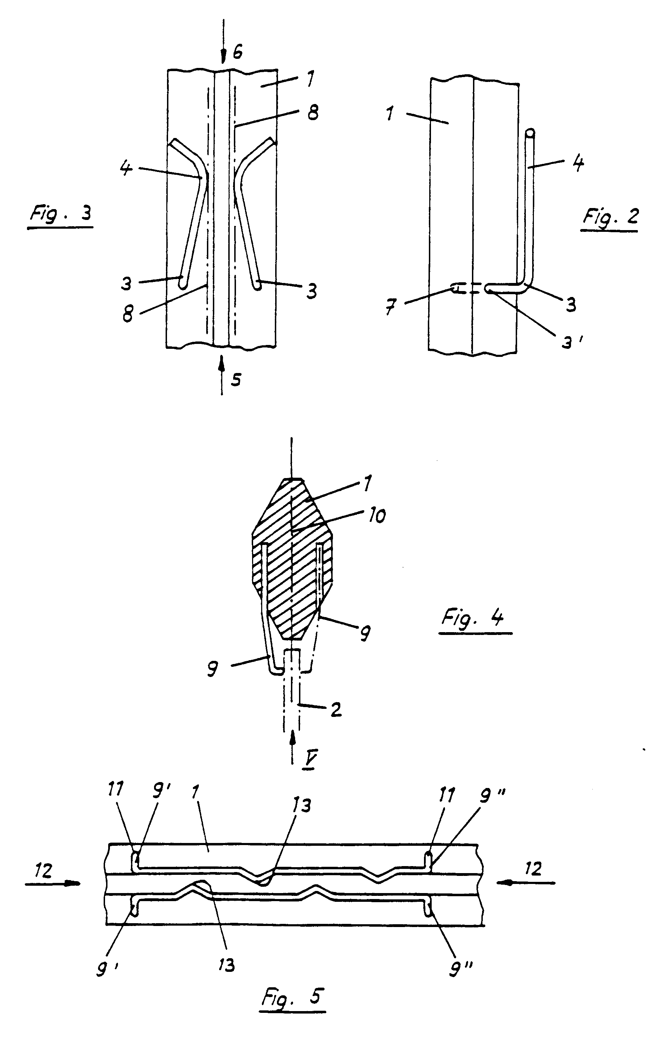

In den verschiedenen Ausführungsbeispielen sind die stangenartigen Gestelle jeweils 1 und die von ihnen gehaltenen Leiterplatten mit 2 beziffert. Im Beispiel der Fig. 1 - 3 sind an den Gestellen 1 Paare zusammengehörender Klemmfedern 3 vorgesehen, die in diesem Beispiel leicht abgewinkelt sind und damit an der Stelle 4 die dazwischen eingeschobene Leiterplatte mit federnder Klemmkraft halten (dies ist nur schematisch der Fig. 1 zu entnehmen)). Die entsprechende Lage der Leiterplatte ist, unter Auseinanderdrücken der Federn 3.dabei in Fig. 3 strichpunktiert dargestellt. Es ist ersichtlich, daß die Formgebung der Federn 3 so ist, daß die Leiterplatten entweder in Pfeilrichtung 5 oder auch in Pfeilrichtung 6, d.h. parallel zu den Gestellen 1 zwischen die Federnpaare geschoben bzw. wieder herausgezogen werden können. Die Federn sind mit ihren Enden 3ʹ in Löcher 7 des jeweiligen Gestelles 1 eingesteckt und dort gehalten. Der Galvanisierstrom wird über die Gestelle 1 und die Federn 3 den Leiterplatten 2 zugeführt. Dieses Einstecken der Leiterplatten zwischen die Federn wird durch von den Federn gebildete trichterförmige Einstecköffnungen 8 erleichtert. Insbesondere Fig. 1 und 2 zeigen, daß sich die Federn 3 von den Gestellen 1 her frei erstrecken, so daß die Gestelle 1 selber nicht das Einschieben der Leiterplatten 2 behindern. Die jeweiligen Federn ragen in den Raum zwischen beiden Gestellen 1 hinein, so daß eine gleichmäßige Galvanisierung erfolgt.

Fig. 1 zeigt ferner, daß in einem Gestell mehrere Leiterplatten übereinander angeordnet werden können und daß auch in waagerechter Richtung mehrere Leiterplatten 2 vorgesehen sein können, da die Gestelle an jeder Seite eine Reihe von übereinander angeordneten Klemmfederpaaren aufweisen können (siehe das in Fig. 1 links dargestellte Gestell).

Die Gestelle und Federn können aus Titan bestehen. Auch wäre die Verwendung von Edelstahl möglich. Dies gilt auch für die übrigen Ausführungsbeispiele. An dieser Stelle sei bemerkt, daß bei einem der Ausführungsbeispiele beschriebene Merkmale sinngemäß auch bei anderen Ausführungsbeispielen verwendet werden, bzw. mit dort vorgesehenen Merkmalen kombiniert werden können.

Vom Prinzip her könnte anstelle zweier zusammenwirkender Klemmfedern auch nur eine Feder mit einem starren Gegenlager vorgesehen sein, doch empfiehlt sich zwecks Erhöhung der Federkraft, daß jeweils zwei Federn zusammenwirken.

Das Ausführungsbeispiel der Fig. 4 und 5 zeigt zunächst eine Formgebung des Querschnittes der Gestelle 1, die auch bei den übrigen Ausführungsbeispielen mit Vorteil vorgesehen ist. Diese Formgebung ist in Richtung der Erstrekkung der in diesem Beispiel mit 9 bezifferten Federn langgestreckt, z. B. in Form eines Rhombus, dessen lange Achse 10 in der Richtung der Federn läuft. Die Leiterplatte 2 ist wieder strichpunktiert angedeutet (sie hält in dieser Lage die Federn 9 auseinandergedrückt). Hierdurch wird eine vorteilhafte, relativ geringe Abschirmung der sich feldlinienartig ausbreitenden Galvanisierströme in Bezug auf die Leiterplatte 2 erreicht. Eine zu starke Abschirmung, wie sie z. B. durch eine im Querschnitt quadratische Form des Gestelles gegeben wäre, hätte zur Folge, daß an den Rändern der Leiterplatten zu wenig Galvanikmaterial aufgetragen wird. Die Querschnittsverstärkung des Gestells 1 in der Mitte dient der Erhöhung ihrer mechanischen Festigkeit und der besseren Stromleitung.

Die Federn 9 sind in diesem Ausführungsbeispiel mit ihren beiden Enden 9ʹ, 9ʺ in entsprechenden Löchern 11 des Gestelles 1 gehalten und zwar bevorzugt unter einer in Federlängsrichtung wirkenden Vorspannung, wodurch besondere Maßnahmen wie Schweißungen zum Halt der Federn unnötig sind (siehe Fig. 5). Fig. 5 zeigt ferner einen Abstand a zwischen den sich gegenüberliegenden Federn, wodurch die Leiterplatten von jeder Seite her in Pfeilrichtung 12 leicht einschiebbar sind. Die Federn 9 besitzen nach innen bzw. zueinander hin gerichtete Auswölbungen 13, die bevorzugt (siehe ebenfalls Fig. 5) zueinander versetzt sind und die eingeschobenen Leiterplatten zwischen sich klemmend halten.

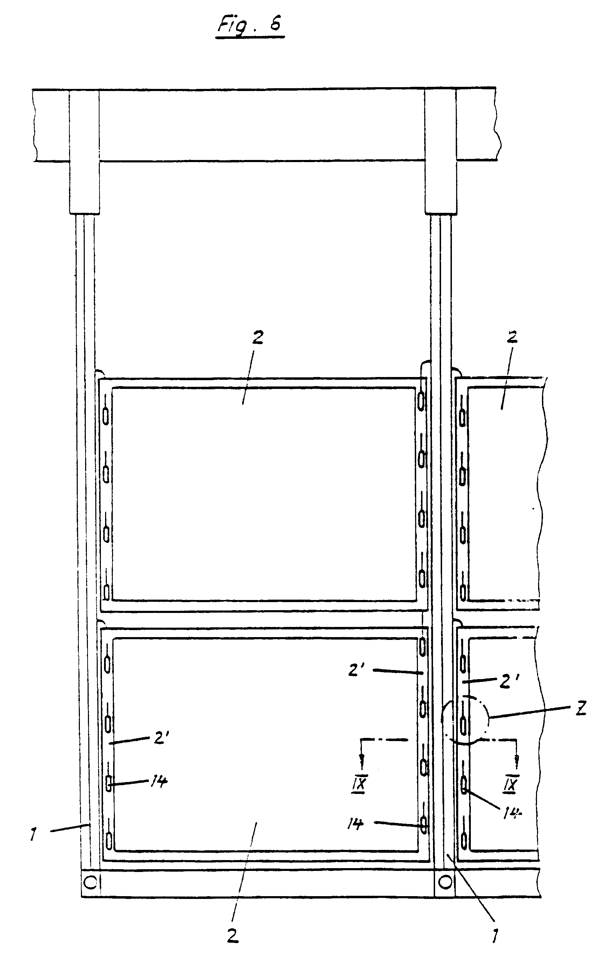

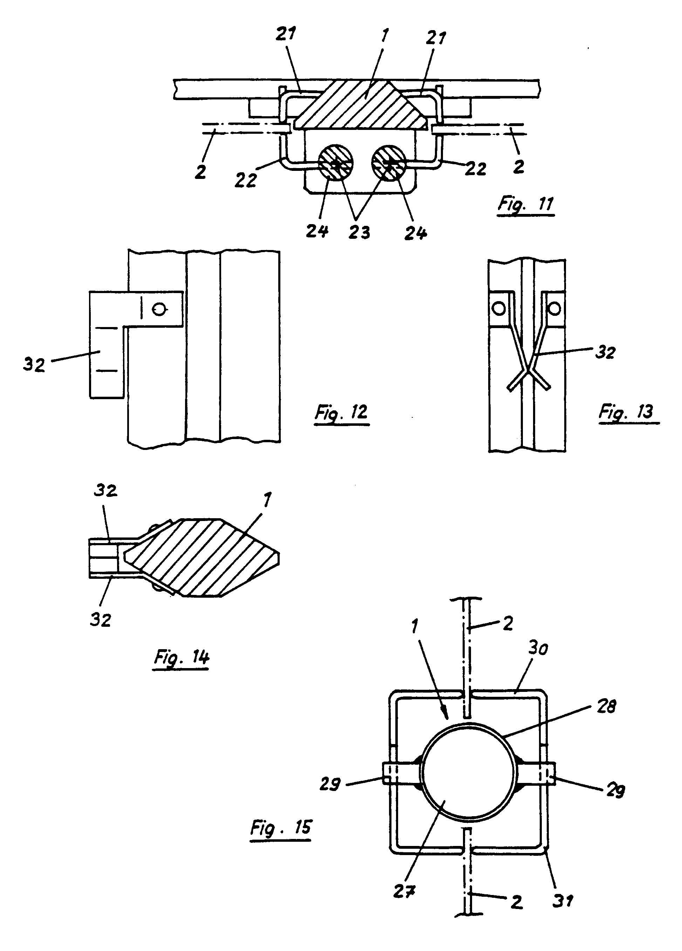

Die Leiterplatten können an ihren Seitenlängsrändern 2ʹ eine oder mehrere Öffnungen, bevorzugt in Form von Langlöchern aufweisen, die in der Klemmhaltelage der Platten über ein Tragelement des jeweiligen Gestelles greifen und damit zusätzlich zur Klemmhalterung durch die Federn einen Halt bzw. Sicherung der Leiterplatte 2 in ihrer Galvanisierposition darstellen. Ausführungsbeispiele eines solchen, zusätzlichen Haltes sind in den Fig. 6-9, sowie in den Fig. 10, 11 dargestellt und nachstehend beschrieben.

Das Ausführungsbeispiel der Fig. 6-9 zeigt Leiterplatten 2, an deren Längsseitenrändern 2ʹ eine Reihe von Langlöchern 14 vorgesehen sind. Fig. 6 zeigt hierzu, daß ein Gestell 1 an jeder Seite Leiterplatten 2 hält (wie es auch schon anhand der Fig. 1 erläutert wurde).

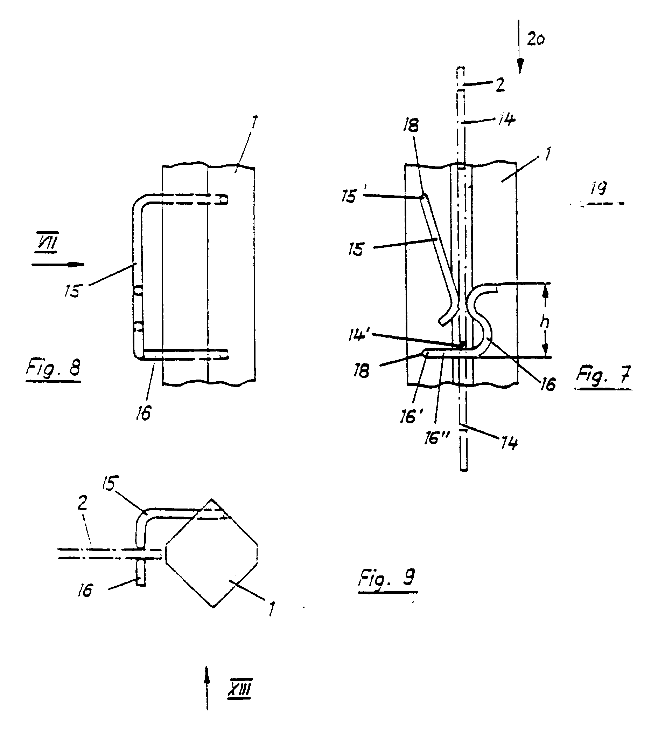

In diesem Ausführungsbeispiel sind jeweils zwei zusammenwirkende Klemmfedern 15, 16 vorgesehen, von denen die jeweilige, S-förmig gebogene Feder 16 die Funktion des Tragelementes übernimmt. Sie ist mit ihrem Ende 16ʹ in einem Loch 18 des Gestelles 1 gehalten. Auch die Feder 15 ist mit ihrem Ende 15ʹ in ein entsprechendes Loch 18 eingesteckt. Die Höhe h des S-förmigen Teiles der Feder 16 ist etwas kleiner bemessen als die Länge der Öffnungen 14. Somit kann eine in Fig. 7 angedeutete Leiterplatte 2 mit der jeweiligen Öffnung 14 in Pfeilrichtung 19 über den S-förmigen Teil gesteckt werden (zugleich auch über die S-förmigen Teile der darüber oder darunter befindlichen Federanordnungen). Danach wird die Leiterplatte 2 in Richtung des Pfeiles 20 etwas nach unten bewegt, bis sie die strichpunktierte Lage gemäß Fig. 7 einnimmt, in der ihre Oberkante 14ʹ auf dem Haltearm 16ʺ der Feder 16 aufliegt.

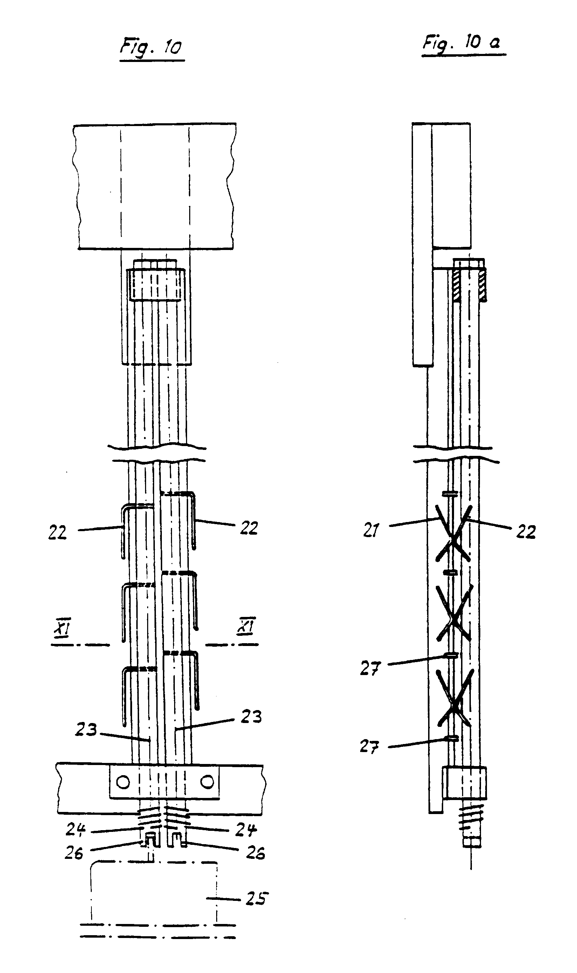

In den Teildarstellungen gemäß Fig. 7 stellt Fig. 9 einen Schnitt der Linie IX-IX in Fig. 6 dar, der außerdem eine Variante in der Querschnittsgestaltung des Gestelles 1 zeigt (dieser Querschnitt ist nicht so langgestreckt wie im Ausführungsbeispiel der Fig. 4). Fig. 8 ist eine Ansicht auf Fig. 9 gemäß dem Pfeil VIII und Fig. 7 eine Ansicht auf Fig. 8 gemäß dem Pfeil VII. Auch hier sind also die Federn 15, 16 vom Gestell 1 her nach innen in Richtung zum gegenüberliegenden Gestell gelegen (in Fig. 6 sind die Federn nicht dargestellt).

Im Beispiel der Fig. 10, 11 sind an dem Gestell 1 links und rechts, d.h. ebenfalls zu dem gegenüberliegenden Gestell hin gerichtet, Feder-Paare vorgesehen, die aus fest am Gestell angebrachten Federn 21 und damit zusammenwirkenden, aber um die Längsachsen 23 von Wellen 24 mit den Wellen verschwenkbaren Federn 22 bestehen. Fig. 11 zeigt die Federpaare 21, 22 in der Klemmstellung. Die Leiterplatten 2 nehmen dabei die strichpunktiert angedeutete Lage ein, in der die Klemmfedern (siehe die Darstellung in Fig. 11) von außen an den Leiterplattenflächen anliegen. Durch Schwenken der in Fig. 11 linken Welle im Gegenuhrzeigersinn und der in Fig. 11 rechten Welle im Uhrzeigersinn werden die Federn 22 aus der Klemmlage gebracht und die Platten 1 können abgenommen bzw. neue Platten in die Galvanisierposition eingebracht werden. Durch Drehen der linken Welle 24 im Uhrzeigersinn und der rechten Welle 24 im Gegenuhrzeigersinn wird die Klemmlage wieder hergestellt. Dieses Ausführungsbeispiel der Erfindung eignet sich besonders zur automatisierten Einbringung der Leiterplatten in die Klemmlage und Wiederherausnehmen der Leiterplatten, da die Bewegung der Leiterplatten maschinell gekoppelt werden kann mit einer entsprechend synchron dazu erfolgenden Drehung der Welle 24 wie vorstehend beschrieben. Hierzu kann (siehe Fig. 10) ein Drehmagnet 25, der auf eines der Enden 26 der Wellen 24 aufgefahren wird, dieses im vorbeschriebenen Sinne um die Achse 23 drehen. Durch zwei Mitnehmerzahnräder wird dann die andere Welle 24 im Gegendrehsinn mit bewegt.

Im Ausführungsbeispiel der Fig. 10, 11 sind ferner am Gestell 1 Halte- oder Tragstifte 27 befestigt, über die die Platten 2 in der zur Galvanisierung dienenden Betriebslage (Klemmlage) mit nicht dargestellten Löchern steckbar sind. Diese Steckverbindung sichert die Leiterplatten 2 gegen ein Herunterfallen während der Montagephasen, in denen die Federn 21, 22 nicht mit Klemmkraft an den Leiterplatten anliegen.

In beiden Ausführungsbeispielen nach Fig. 6 bis 9 und Fig. 10 bis 11 müssen die Leiterplatten nicht von unten oder oben her in Längsrichtung der Gestelle zwischen Klemmfedern geschoben werden, sondern können vielmehr frontal in einer quer zu ihrer Plattenebene verlaufenden Richtung aufgebracht und abgenommen werden. Dies ist dann erforderlich, wenn kein Platz zum Einschieben der Leiterplatten von oben oder von unten her besteht. Es ist nicht nur bequemer, sondern in der Regel auch schneller als das Einstecken in Längsrichtung der Gestelle. Auch in diesen Ausführungsbeispielen sind die Gestelle so zu formen, daß nachteilige Abschirmungen des zu galvanisierenden Gutes vom Galvanisierstrom nicht eintreten.

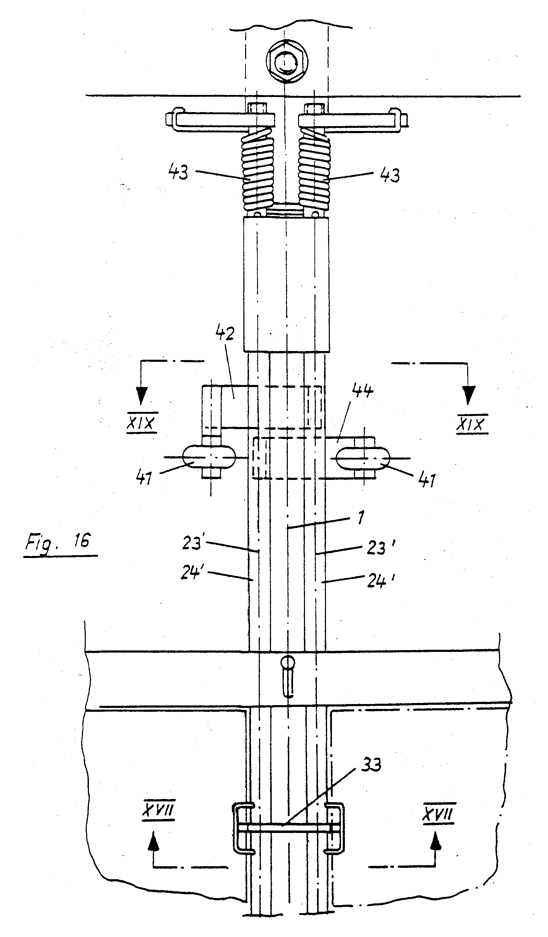

Eine bevorzugte Ausführungsform eines Gestelles 1 mit zwei Schwenkwellen ist nachstehend anhand der Fig. 16 bis 18 beschrieben. Hiermit soll eine möglichst günstige Feldverteilung, d.h. Verlauf der Stromlinien im Galvanisierbad erreicht und damit vermieden werden, daß das Gestell und die Schwenkwellen von den Leiterplatten zuviel an Feldlinien beim Galvanisiervorgang abschirmen, was eine ungenügende Galvanisierung der Ränder der Leiterplatten zur Folge hätte. Zu diesem Zweck sind die hier mit 24ʹ bezifferten Schwenkwellen auf einander entgegengesetzten Seiten des stabförmigen Gestelles 1 angeordnet, so daß die Mittellängsachsen 23ʹ der Schwenkwellen 24ʹ mit der Mittellängsachse 1ʹ des Gestelles 1 in etwa fluchten und in einer Ebene liegen. Die Schwenkwellen 24ʹ verlaufen auch hier parallel zum Gestell 1. Hierdurch erhält man eine sehr langgestreckte die vorgenannten Nachteile vermeidende Ausführung (siehe auch die entsprechenden Ausführungen zu Fig. 4).

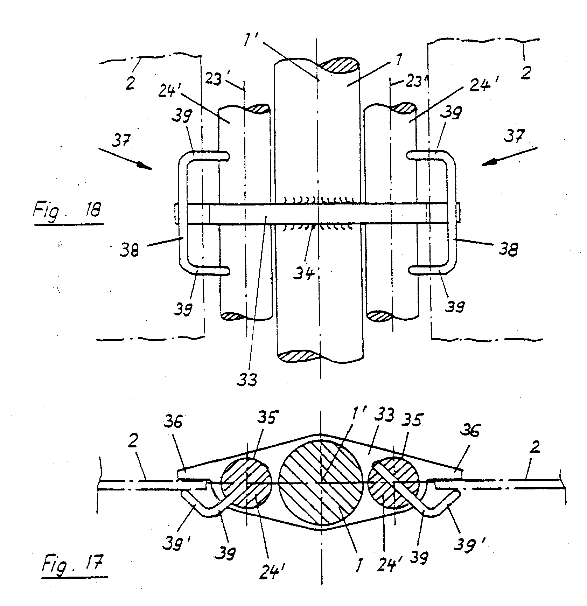

Insbesondere Fig. 17 zeigt, daß in Konsequenz des Vorstehenden in der Klemmhalterung der hier strichpunktiert dargestellten Leiterplatten 2, diese mit den Schwenkwellen 24ʹ und bevorzugt auch dem Gestell 1 fluchten. Der Zusammenhalt des Gestelles 1 und der beiden Schwenkwellen 24ʹ kann in einer konstruktiv vorteilhaften und einfachen Ausführung mit Hilfe von Trag- und Führungsplatten 33 erfolgen. Das Gestell 1 durchsetzt je eine Bohrung dieser Platten 33 und ist daran starr befestigt, z.B. mittels einer Schweißung 34. In weiteren, je ein Drehlager 35 bildenden Bohrungen der Platten 33 sind die Schwenkwellen 24ʹ drehbar gelagert, im übrigen aber davon in ihrer Position gehalten. Je nach der Länge des Gestelles ist eine entsprechende Anzahl von Trag- und Führungsplatten 33 in Abständen voneinander an den Gestellen befestigt.

Eine weitere bevorzugte Ausführung der Erfindung besteht darin, daß die Trag- und Führungsplatten 33 zugleich stromführend sind (dies geschieht aufgrund ihrer starren und zugleich leitenden Verbindung mit den Gestellen 1) und ferner in der dargestellten Klemmlage Widerlager 36 für die zu galvanisierenden Leiterplatten 2 sind. Der Gegenpol der Stromübertragung wird von Klemmfedern 37 gebildet, die etwa U-förmig mit einem Steg 38 und abgewinkelten Schenkeln 39 ausgebildet sind. Die Schenkel 39 sind fest, zumindest auf Drehmitnahme fest in den Schwenkwellen 24ʹ oberhalb und unterhalb der zugehörigen Trag- und Führungsplatte 3 angebracht. Die Schenkel 39 sind ferner so abgewinkelt, daß ihre den Steg 38 tragenden Enden 39ʹ zum Widerlager 36 hin gereichtet sind, so daß eine einwandfreie Klemmhalterung der Leiterplatten 2 erreicht wird (siehe insbesondere Fig. 17). Die Stege 38 verlaufen etwa in Längsrichtung der Schwenkwellen.

Das Ausführungsbeispiel der Fig. 12 bis 13 zeigt in der Seitenansicht (Fig. 12), Stirnansicht (Fig. 13) und Schnitt (Fig. 14), daß die Federn 32 auch als Flachfedern, d.h. aus flachem Stahlband hergestellt sein können. Dies ergibt vorteilhafterweise einen Linienkontakt und damit eine größere Kontaktfläche als bei Federn aus im Querschnitt runden Federdraht, die nur einen Punktkontakt ermöglichen. Wie oben bereits erwähnt, kann auch dieser Gedanke der Erfindung bei den anderen Ausführungsbeispielen sinngemäß, d.h. unter Übernahme der dort beschriebenen Federgestaltungen und An. bringen usw. vorgesehen sein.

Insbesondere beim Arbeiten mit hohen Stromdichten zur schnellen Abscheidung empfiehlt sich eine Ausgestaltung der Gestelle und der Tragmittel für die Federn gemäß Fig. 15. Hier besteht das jeweilige Gestell 1 aus einer Kupferseele 27 mit einer Ummantelung 28 aus Titan. Ferner sind aus Titan bestehende Tragarme 29 für die Klemmfedern 30, 31 vorgesehen. Die Leiterplatten sind mit 2 angedeutet. Nachteilige Spannungsabfälle werden mit dieser Anordnung vermieden.

Grundsätzlich gilt bei allen Ausführungsbeispielen, daß Leiterplatten 2 von den erfindungsgemäßen Gestellen sowohl übereinander als auch nebeneinander in einem galvanischen Bad gehalten werden können. Wie z. B. Fig. 1 zeigt, können die Gestelle 1 in üblicher Weise oberseitig durch einen Gestellträger 1ʹ miteinander verbunden sein.

Alle Gestellausführungen nach der Erfindung können nach dem Entfernen der Leiterplatten im Säurebad gereinigt (gestrippt) werden. Alle Gestelle können leicht mit einem nichtleitendem säurebeständigen Überzug isoliert werden, so daß unerwünschte galvanische Niederschläge unterbleiben. Lediglich die Kontaktspitzen der Federn bleiben blank. Das Strippen (Reinigen im Säurebad) beschränkt sich dann auf diese Kontakte.

## Patentansprüche

1. Langgestreckte Gestelle und zugehörige Teile zum lösbaren Befestigen von Leiterplatten für die nachfolgende Galvanisierung mit Mitteln, um die Leiterplatten an ihren beiden einander gegenüberliegenden Längsseitenrändern zu halten, wobei die Haltemittel auch der Stromzuführung dienen, dadurch gekennzeichnet, daß zwei einander parallele und im Abstand angeordnete Gestelle jeweils in sich federnde Klemmhalterungen (3: 9; 15, 16; 21, 22; 32) aufweisen, daß diese Klemmhalterungen von jedem Gestell (1) her frei wegragen und zwar in den Raum zwischen diesen beiden Gesellen hinein und daß Mittel vorgesehen bzw. die Klemmhalterungen so ausgebildet sind, daß ein Einbringen bzw. Wiederherausnahmen der jeweiligen Längsseitanränder der zu galvanisierenden Flächen der Leiterplatten in die bzw. aus den federnden Klemmhalterungen dieser beiden Gestelle entweder durch Einschieben der Leiterplatten in deren Klemmhalterungen oder dadurch ermöglicht ist, daß ein Teil (21) der Klemmfedern dar federnden Klemmhalterungen am jeweiligen Gestell (1) in die Klemmlage schwenkbar und aus dieser in eine Freigabestellung ausschwankbar gelagert ist.

2. Gestelle nach Anspruch 1, dadurch gekennzeichnet, daß jedes Gestell (1) eine Anzahl von in Gestell-Längsrichtung übereinander und im Abstand voneinander angeordneten Klemmfederhalterungen (3; 9; 15, 16; 32) aufweist und daß die Klemmfederhalterungen eine Formgebung aufweisen, die ein Einschieben der Längsseitenränder (2') der Leiterplatten (2) in Geste-Längsrichtung zwischen die Federn der Klemmfederhalterung ermöglicht.

3. Gestelle nach Anspruch 2, dadurch gekennzeichnet, daß die Federn der Klemmfederhalterung jeweils ein sich entgegen der Einschubrichtung der jeweiligen Leiterplatte (2) erweiternde, etwa trichterförmige Einschuböffnung (8) bilden.

4. Gesteile nach einem der Ansprüche 1 bis 3, dadurch gekennzeichnet, daß die Klemmfederhalterungen (3; 9; 15, 16; 21, 22; 32) von zwei zusammenwirkenden Klemmfedern gebildet sind.

5. Gestelle nach einem der Ansprüche 2 bis 4, dadurch gekennzeichnet, daß das der jeweiligen trichterförmigen Öffnung abgewandte Federende (3'; 15'; 16') in einem Loch (7; 18) einer das Gestell (1) bildenden Stange gehalten ist.

6. Gestelle nach einem der Ansprüche 2 bis 4, dadurch gekennzeichnet, daß die Federn (9) mit beiden Enden (9') in Löchern (11) einer das Gestell (1) bildenden Stange gehalten sind und daß die Federn in einem Abstand (a), zwischen sich eine Einschuböffnung bildend, angeordnet sind, wobei die Federn zueinander hin gerichtete Auswölbungen (13) oder dergleichen Vorsprünge aufweisen, welche in der Haltelage die Leiterplatten (2) klemmend erfassen.

7. Gestelle nach Anspruch 6, dadurch gekennzeichnet, daß die Auswölbungen oder dergleichen (13) beider zusammengehörender Federn (9) in der Längsrichtung zueinander versetzt sind, so daß in der Klemmlage nicht zwei Auswölbungen zweier Federn einander gegenüberliegen.

8. Gestelle nach Anspruch 6 oder 7, dadurch gekennzeichnet, daß die Federn (9) mit Vorspannung in den Löchern (11) gehalten sind.

9. Gestelle nach einem der Ansprüche 2 bis 8, dadurch gekennzeichnet, daß der Querschnitt der die Federn haltenden, das Gestell (1) bildenden Stange in Längsrichtung der Federn und damit in Längsrichtung der zwischen den Federn gehaltenen Leiterplatte langgestreckt ist (Fig. 4).

10. Gestelle nach Anspruch 9, dadurch gekennzeichnet, daß der Stangenquerschnitt etwa rhombisch ist, wobei die lange Achse (10) des Rhombus in Federlängsrichtung bzw. in Leiterplatten-Längsrichtung verläuft.

11. Gestelle nach einem der Ansprüche 1 bis 10 und zugehöriger Leiterplatten, dadurch gekennzeichnet, daß die Leiterplatten (2) an ihren Seitenlängsrändern (2') mit zumindest einer Öffnung (14), bevorzugt Langlöchern versehen ist, die in der Klemmhaltelage der jeweiligen Leiterplatte über ein Tragelement des jeweiligen Gestelles greift bzw. greifen.

12. Gestelle und zugehörige Leiterplatten nach Anspruch 11, dadurch gekennzeichnet, daß als Tragelement die Klemmhalterungen selber dienen.

13. Gestelle und zugehörige Leiterplatten nach Anspruch 12, dadurch gekennzeichnet, daß eine Klemmfeder (16) etwa S-förmig gebogen ist, wobei dieser S-Teil etwas kleiner ist als die Öffnung (14) der Leiterplatte und somit in einer Richtung quer zur Leiterplattenebene durch diese hindurchführbar ist.

14. Gestelle nach einem der Ansprüche 1, 9 bis 13, dadurch gekennzeichnet, daß ein Teil der Klemmfedern (21) am Gestell (1) starr und der andere Teil (22) der Klemmfedern zum Gestell (1) schwenkbar gelagert ist.

15. Gestelle nach Anspruch 14 gekennzeichnet durch in Längsrichtung des Gestelles (1) verlaufende, drehbare Schwenkwellen (24,24')an denen die zu verschwenkenden Klemmfedern (22) befestigt sind.

16. Gestelle nach Anspruch 15, dadurch gekennzeichnet, daß die beiden Schwenkwellen (24') an einander entgegengesetzten Seiten des langgestreckten, etwa stabförmigen Gestelles (1) angeordnet sind, wobei die Mittellängsachsen (23') der Schwenkwellen etwa mit der Mittellängsachse (1') des Gestelles fluchtend in einer gemeinsamen Ebene liegen.

17. Gestelle nach einem der Ansprüche 14 bis 16, dadurch gekennzeichnet, daß die Schwenkwellen (24') und oder das Gestell (1) in der Klemmstellung mit den Leiterplatten (2) fluchten.

18. Gestelle nach einem der Ansprüche 14 bis 17, gekennzeichnet durch Trag- und Führungsplatten (33), die in Abständen voneinander am Gestell befestigt und als Drehlager für die Schwenkwellen (24') ausgebildet sind.

19. Gestelle nach Anspruch 18, dadurch gekennzeichnet, daß die Trag- und Führungsplatten (33) zugleich als leitend am Gestell (1) angebrachte, stromführende Widerlager (36) für die Leiterplatten (2) ausgebildet sind.

20. Gestelle nach Anspruch 19, dadurch gekennzeichnet, daß die beweglichen Klemmfedern (38) etwa U-förmig gebogen und mit ihren Schenkeln (39) in den Schwenkwellen (24') derart befestigt sind, daß ihre Stege (38) in Längsrichtung der Schwenkwellen (24') verlaufen und in der Klemmlage an den Leiterplatten (2) anliegend diese gegen das jeweilige Widerlager (36) der Trag- und Führungsplatte (33) drücken.

21. Gestelle nach Anspruch 20, dadurch gekennzeichnet, daß der aus den Schwenkwellen (24') herausragende Teil der Schenkel (39) der Klemmfedern in Richtung zum Widerlager (36) der Trag- und Führungsplatte (33) abgewinkelt ist (39') und daß diese Abwinkelungen den jeweiligen Steg (38) halten.

22. Gestelle nach einem der Ansprüche 14 bis 21, dadurch gekennzeichnet, daß mit einer gesteuerten Vorrichtung zum Anbringen und Abnenmen der Leiterplatten (2) an bzw. vom Gesteil (1) eine maschinelle Betätigung des Bringens der beweglichen Klemmhalterung (22) in die bzw. aus der Klemmlage gekoppelt ist.

23. Gestelle nach einem der Ansprüche 1 bis 22, dadurch gekennzeichnet, daß die Klemmfedern (32) aus einem Flachband gebildet sind.

24. Gestelle nach einem der Ansprüche 1 bis 23, dadurch gekennzeichnet, daß die die Klemmfedem tragenden, etwa stangenartigan Gestelle (1) einen aus Kupfer bestehenden Kern oder Seele (27) mit einer außenseitigen Titan-Umhüllung (28) aufweisen.

25. Gestelle nach Anspruch 24, gekennzeichnet durch von der Titanumhüllung (28) nach außen abstehende, aus Titan bestehende Rippen (29) zum Halt der Klemmfedern (30, 31).

## Claims

1. Elongated racks and associated parts for the detachable fixing of printed circuit boards for subsequent electroplating, with means for holding the printed circuit boards by their two opposite longitudinal edges, the holding means also serving to feed the current,
**characterised in that** two parallel racks disposed at a distance from one another have inherently resilient clamp mounts (3; 9; 15; 16; 21; 32),
**in that** these clamp mounts protrude freely form each rack (1) and namely into the space between these two racks,
**and in that** means are provided and/or the clamp mounts are designed in such a way that it is possible to insert and/or remove the respective longitudinal edges of the surfaces to be electroplated of the printed circuit boards into or from the resilient clamp mounts of these two racks either by sliding the printed circuit boards in their clamp mounts or by the fact that one part (21) of the clamping springs of the resilient clamp mounts at the respective rack (1) is mounted so that it can be swivelled into the clamping position and out of it into a released position.

2. Racks in accordance with Claim 1,
**characterised in that** each rack (1) has a number of
resilient clamp mounts (3; 9; 15; 16; 32) accommodated in the longitudinal direction of the rack above each other and apart from each other,
**and in that** the resilient clamp mounts have a form which makes it possible to slide the longitudinal edges (2') of the printed circuit boards (2) between the springs of the resilient clamp mounts in the longitudinal direction of the rack.

3. Racks in accordance with Claim 2,
**characterised in that** the springs of the resilient clamp mount each form a roughly funnel-shaped insertion opening (8) with its open end facing the direction of insertion of the respective printed circuit board (2).

4. Racks in accordance with one of Claims 1 to 3, **characterised in that** the resilient clamp mounts (3; 9; 15; 16; 21; 22; 32) are formed by two clamping springs that work together.

5. Racks in accordance with one of Claims 2 to 4, **characterised in that** the end of the spring (3'; 15'; 16') facing away from the respective funnel-shaped opening is held in a hole (7; 18) of a bar forming the rack (1).

6. Racks in accordance with one of Claims 2 to 4, **characterised in that** the springs (9) are held with both ends (9') in holes (11) of a bar forming the rack (1), **and in that** the springs are arranged at a distance (a) from each other, thus forming an insertion opening between them, the springs having indentations (13) pointing toward one another or similar projections, which clamp the printed circuit boards (2) in the holding position.

7. Racks in accordance with Claim 6,
**characterised in that** the indentations or the like (13) of both springs (9) which belong together are staggered with regard to one another in the longitudinal direction so that two indentations of two springs are not opposite one another in the clamping position.

8. Racks in accordance with Claim 6 or 7,
**characterised in that** the springs (9) are held in the holes (11) by a prestressing force.

9. Racks in accordance with one of Claims 2 to 8, **characterised in that** the cross section of the bar holding the springs and forming the rack (1) is elongated in the longitudinal direction of the springs and thus in the longitudinal direction of the printed circuit board held between the springs (Fig. 4).

10. Racks in accordance with Claim 9,
**characterised in that** the cross section of the bar is roughly rhombic, the long axis (10) of the rhombus running in the longitudinal direction of the springs or in the longitudinal direction of the printed circuit board.

11. Racks in accordance with one of Claim 1 to 10 and associated printed circuit boards,
**characterised in that** the printed circuit boards (2) are provided with at least one opening (14), preferably slots, on their longitudinal edges (2'), which in the clamping holding position of the respective printed circuit board engages or engage over a supporting element of the respective rack.

12. Racks and associated printed circuit boards in accordance with Claim 11,
**characterised in that** the clamp mounts themselves serve as the supporting element.

13. Racks and associated printed circuit boards in accordance with Claim 12,
**characterised in that** a clamping spring (16) is bent roughly in an S shape, this S-part being slightly smaller than the opening (14) in the printed circuit board and thus able to pass though the same in a direction perpendicular to the plane of the printed circuit board.

14. Racks in accordance with one of Claims 1, 9 to 13,
**characterised in that** one part of the clamping springs (21) on the rack (1) is mounted rigidly and the other part (22) of the clamping springs is mounted so as to be able to swivel in relation to the rack (1).

15. Racks in accordance with Claim 14,
**characterised by** revolving swivelling shafts (24, 24') running in the longitudinal direction of the rack (1), to which the clamping springs (22) to be swivelled are attached.

16. Racks in accordance with Claim 15,
**characterised in that** the two swivelling shafts (24') are arranged on opposite sides of the elongated, roughly rod-shaped rack (1), wherein the centre lines (23') of the swivelling shafts are roughly aligned in a common plane with the centre line (1') of the rack.

17. Racks in accordance with one of Claims 14 to 16,
**characterised in that** the swivelling shafts (24') and/or the rack (1) are aligned with the printed circuit boards (2) in the clamped position.

18. Racks in accordance with one of Claims 14 to 17,
**characterised by** support and guide plates (33) which are attached to the rack at distances from each other and are designed as pivots for the swivelling shafts (24').

19. Racks in accordance with Claim 18,
**characterised in that** the support and guide plates (33) are designed at the same time as conductive abutments (36) mounted on the rack ( 1 ) for the printed circuit boards (2).

20. Racks in accordance with Claim 19,
**characterised in that** the moving clamping springs (38) are bent roughly in the shape of a U and are attached in the swivelling shafts (24') with their legs (39) in such a way that their webs (38) run in the longitudinal direction of the swivelling shafts (24') and, abutting the printed circuit boards (2) in the clamped position, press the same against the respective abutment (36) of the support and guide plate (33).

21. Racks in accordance with Claim 20,
**characterised in that** the part of the legs (39) of the clamping springs protruding from the swivelling shafts (24') is angled (39') in the direction of the abutment (36) of the support and guide plate (33), **and in that** these angles hold the respective web (38).

22. Racks in accordance with one of Claims 14 to 21,
**characterised in that** an actuating mechanism for bringing the moving clamp mount (22) into the clamped position or for removing it therefrom is linked to a controlled device for taking the printed circuit boards (2) to or from the rack (1).

23. Racks in accordance with one of Claims 1 to 22,
**characterised in that** the clamping springs (32) are made of flat steel.

24. Racks in accordance with one of Claims 1 to 23,
**characterised in that** the roughly bar-shaped racks (1) carrying the clamping springs have a core (27) made of copper with a titanium sheath (28) on the outside.

25. Racks in accordance with Claim 24,
**characterised by** ribs (29) made of titanium outwardly protruding from the titanium sheath (28) to hold the clamping springs (30, 31).

## Revendications

1. Supports allongés et pièces correspondantes pour fixer de façon amovible des plaquettes de circuits imprimés pour les galvaniser ultérieurement, avec des moyens pour maintenir les plaquettes par leurs deux bords longitudinaux opposés, les moyens de fixation servant également à amener le courant, caractérises en ce que deux supports parallèles entre eux et disposés de façon écartée présentent des dispositifs de serrage faisant ressort en soi (3 ; 9 ; 15 ; 16 ; 21 , 22 ; 32), en ce que ces dispositifs de serrage dépassent librement de chaque support (1), de préférence dans l'espace situé entre ces deux supports, et en ce que des moyens sont prévus ou les dispositifs de serrage sont configurés de manière à permettre une mise en place ou un retrait des bords longitudinaux des surfaces à galvaniser des plaquettes de circuits imprimés dans les ou hors des dispositifs de serrage à ressorts de ces deux supports soit en insérant les plaquettes de circuits imprimés dans leurs dispositifs de serrage, soit par le fait qu'une partie (21) des ressorts de serrage des dispositifs de serrage à ressorts est montée de façon à pouvoir pivoter en position de serrage sur le support (1) et à pivoter de cette position dans une position de libération.

2. Supports selon la revendication 1, caractérisés en ce que chaque support (1) présente un certain nombre de dispositifs de serrage à ressorts (3 ; 9 ; 15 , 16 ; 32) superposés dans la direction longitudinale du support et disposés de façon écartée les uns des autres, et en ce que les dispositifs de serrage à ressorts ont une forme permettant d'insérer les bords longitudinaux (2') des plaquettes de circuits imprimés (2) entre les ressorts du dispositif de serrage à ressorts dans la direction longitudinale du support.

3. Supports selon la revendication 2, caractérisés en ce que les ressorts du dispositif de serrage à ressorts forment chaque fois une ouverture d'insertion (8) en forme d'entonnoir allant en s'élargissant dans le sens opposé au sens d'insertion de chaque plaquette de circuits imprimés (2).

4. Supports selon l'une des revendications 1 à 3, caractérisés en ce que les dispositifs de serrage à ressorts (3 ; 9 ; 15 ; 16 ; 21 ; 22 ; 32) sont constitués par deux ressorts de serrage coopérant entre eux.

5. Supports selon l'une des revendications 2 à 4, caractérisés en ce que l'extrémité du ressort (3' ; 15' ; 16') opposée à l'ouverture en forme d'entonnoir est fixée dans un trou (7 ; 18) prévu dans une barre formant le support (1).

6. Supports selon l'une des revendications 2 à 4, caractérisés en ce que les ressorts (9) sont maintenus à leurs deux extrémités (9') dans des trous (11) prévus dans une barre formant le support (1), et en ce que les ressorts sont disposés avec un écartement (a), formant ainsi entre eux une ouverture d'insertion, les ressorts présentant des parties bombées (13) ou des saillies analogues pointant l'une vers l'autre, qui serrent les plaquettes de circuits imprimés (2) en position de fixation.

7. Supports selon là revendication 6, caractérisés en ce que les parties bombées ou analogues (13) des deux ressorts allant de pair (9) sont décalées l'une par rapport à l'autre dans la direction longitudinale, de sorte qu'en position de fixation, il n'y à pas deux parties bombées de deux ressorts en face l'une de l'autre.

8. Supports selon la revendication 6 ou 7, caractérisés en ce que les ressorts (9) sont maintenus dans les trous (11) avec une précontrainte.

9. Supports selon l'une des revendications 2 à 8, caractérisés en ce que la section de la barre formant le support (1) et maintenant les ressorts est allongée dans la direction longitudinale des ressorts et donc dans la direction longitudinale de la plaquette de circuits imprimés maintenue entre les ressorts (fig. 4).

10. Supports selon la revendication 9, caractérisés en ce que la section de la barre a sensiblement la forme d'un losange, le grand axe (10) du losange s'étendant dans la direction longitudinale du ressort ou des plaquettes de circuits imprimés.

11. Supports selon l'une des revendications 1 à 10 et plaquettes de circuits imprimés correspondantes, caractérisés en ce que les plaquettes de circuits imprimés (2) sont munies sur leurs bords longitudinaux (2') d'au moins une ouverture (14), de préférence d'ouvertures en forme de trous oblongs, ouverture(s) qui, lorsque la plaquette de circuits imprimés est en position de fixation, vient ou viennent en prise avec un élément porteur de chaque support.

12. Supports et plaquettes de circuits imprimés correspondantes selon la revendication 11, caractérisés en ce que les dispositifs de serrage servent eux-mêmes d'élément porteur.

13. Supports et plaquettes de circuits imprimés correspondantes selon la revendication 12, caractérisés en ce qu'un ressort de serrage (16) est cintré approximativement en forme de S, cet élément en forme de S étant légèrement plus petit que l'ouverture (14) de la plaquette de circuits imprimés et pouvant donc être inséré dans celle-ci dans une direction perpendiculaire au plan de la plaquette de circuits imprimés.

14. Supports selon l'une des revendications 1, 9 à 13, caractérisés en ce qu'une partie des ressorts de serrage (21) est montée fixement sur le support (1), tandis que l'autre partie (22) des ressorts de serrage est montée de façon à pouvoir pivoter par rapport au support (1).

15. Supports selon la revendication 14, caractérisés par des arbres pivotants (24, 24') rotatifs disposés dans la direction longitudinale du support (1), arbres sur lesquels sont fixés les ressorts de serrage (22) destinés à pivoter.

16. Supports selon la revendication 15, caractérisés en ce que les deux arbres pivotants (24') sont disposés sur des côtés opposés du support allongé (1) ayant approximativement la forme d'une barre, les axes médians longitudinaux (23') des arbres pivotants se trouvant sensiblement alignés dans un même plan avec l'axe médian longitudinal (1') du support.

17. Supports selon l'une des revendications 14 à 16, caractérisés en ce que les arbres pivotants (24') et/ou le support (1) sont alignés avec les plaquettes de circuits imprimés (2) en position de fixation.

18. Supports selon l'une des revendications 14 à 17, caractérisés par des plaques de support et de guidage (33) fixées sur le support à une certaine distance l'une de l'autre et servant de palier pour les arbres pivotants (24').

19. Supports selon la revendication 18, caractérisés en ce que les plaques de support et de guidage (33) sont en même temps conçues pour servir de butées (36) conductrices de courant disposées sur le support (1) pour les plaquettes de circuits imprimés (2).

20. Supports selon la revendication 19, caractérisés en ce que les ressorts de serrage mobiles (38) sont cintrés approximativement en forme de U et sont fixés par leurs branches (39) dans les arbres pivotants (24') de manière à ce que leurs dos (38) s'étendent dans la direction longitudinale des arbres pivotants (24') et que, tandis qu'ils sont appliqués contre les plaquettes de circuits imprimés (2) en position de fixation, ils appuient ces dernières contre la butée correspondante (36) de la plaque de support et de guidage (33).

21. Supports selon la revendication 20, caractérisés en ce que la partie des branches (39) des ressorts de serrage dépassant des arbres pivotants (24') est coudée (39') en direction de la butée (36) de la plaque de support et de guidage (33), et en ce que ces parties coudées maintiennent le dos (38) des ressorts.

22. Supports selon l'une des revendications 14 à 21, caractérisés en ce qu'un actionnement mécanique destiné à mettre le dispositif de serrage mobile (22) dans la position de serrage ou à lui faire quitter cette position est accouplé à un dispositif commandé pour fixer les plaquettes de circuits imprimés (2) au support (1) et les en retirer.

23. Supports selon l'une des revendications 1 à 22, caractérisés en ce que les ressorts de serrage (32) sont constitués par un feuillard plat.

24. Supports selon l'une des revendications 1 à 23, caractérisés en ce que les supports (1) approximativement en forme de barre supportant les ressorts de serrage sont composés d'un noyau ou âme (27) en cuivre avec une enveloppe extérieure en titane (28).

25. Supports selon la revendication 24, caractérisés par des nervures en titane (29) dépassant de l'enveloppe en titane (28) vers l'extérieur, qui servent à maintenir les ressorts de serrage (30,31).
